# EUROPEAN PATENT APPLICATION

(11) **EP 1 502 922 A1**
(43) Date of publication of application: **02.02.2005**
(21) Application number: 03077384.0
(22) Date of filing: 30.07.2003
(51) Int. Cl.: C08F 2/44, C08G 59/00, G03C 1/73

(54) **Curable encapsulant compositions**

(71) Applicant: Loctite (R & D) Limited, Tallaght, Dublin 24 (IE)
(72) Inventor: Ledwidge, Eadaoin, Lucan Co. Dublin (IE)
(74) Representative: Lane, Cathal Michael

(57) **Abstract**

The present invention is directed to a photocurable composition for use as in particular an encapsulant, capable of curing at wavelengths greater than 290 nm. Reaction products of these photocurable compositions are opaque but good CTV is achieved. The composition is initially substantially transparent but becomes opaque on exposure to uv. The composition cures while the colour change takes place. In use, the photocurable composition may be applied, for instance, over the wire bonds that electrically connect a semiconductor device to a substrate to maintain a fixed positional relationship and protect the integrity of the electrical connection from vibrational and shock disturbances, as well as from interference from environmental contaminants.

## Description

### BACKGROUND OF THE INVENTION

### Field of the Invention

The present invention relates to curable encapsulant compositions in particular curable epoxy based compositions suitable for use as encapsulants. In particular the present invention is directed to a photocurable composition for use as an encapsulant, underfill or attachment adhesive. Typically such compositions are capable of curing at wavelengths greater than 290 nm. In use, the photocurable composition may be applied, for instance, over the wire bonds that electrically connect a semiconductor device to a substrate to maintain a fixed positional relationship and protect the integrity of the electrical connection from vibrational and shock disturbances, as well as from interference from environmental contaminants.

The invention is also directed to methods of preparing such compositions, methods of using such compositions, assembly of microelectronic devices, such as smart cards, with such compositions, and reaction products of such compositions as well as the assembled microelectronic components.

### Brief Description of Related Technology

An integrated circuit assembly typically includes a substrate that forms a physical and structural foundation for an integrated circuit die, which itself is electrically connected to bonding pads on the substrate so as to allow for communication between the die and external devices.

In a smart card application, an integrated circuit module is disposed in a plastic card, similar in size and shape to an ordinary credit or debit card. The integrated circuit module itself includes a microcontroller and a memory device, such as an EPROM, of sufficient size to store large amounts of information, such as personal information, medical history information, financial information, security information, frequent flyer mileage information, and the like. The smart card can also operate as a telephone card with a stored monetary value that is updated with each transaction.

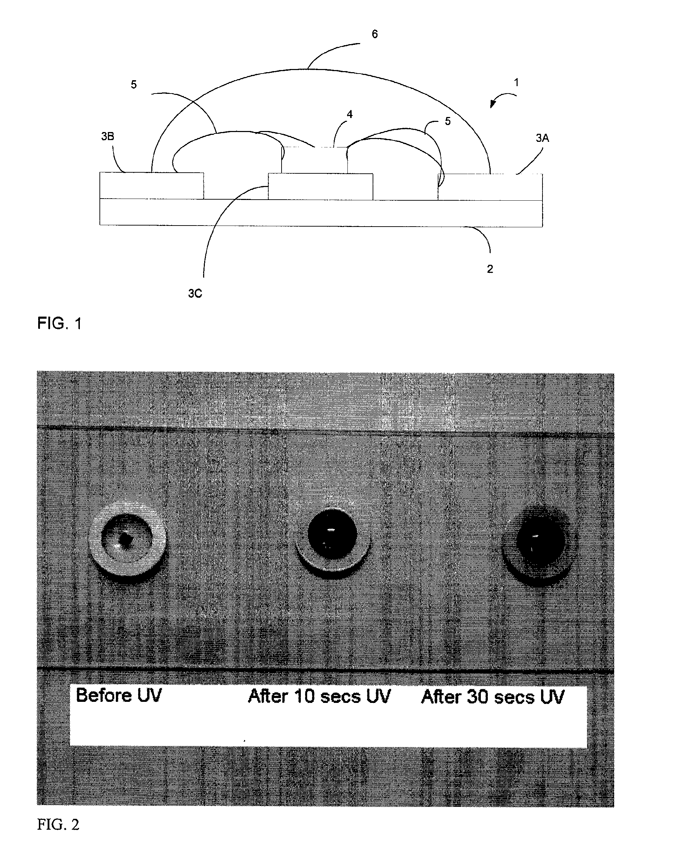

Heretofore, smart cards have included a plastic card, in which is milled out a pocket or cavity dimensioned and disposed to receive an integrated circuit module. The integrated circuit module is constructed of a die disposed over a substrate and electrically connected with gold or aluminium wire bonds. The wire bonds typically rise vertically from the die and bend over to a bonding pad on the substrate. (See FIG. 1.)

In order to protect the wire bonds from fracture or environmental damage, an encapsulant is ordinarily applied thereover. The encapsulant acts to seal in place the wire bonds, providing cushioning against shock (which may lead to fracture) and prevents the ingress of environmental contaminants which may cause an electrical disconnect.

One way to apply such an encapsulant during smart card assembly is by the so-called two-step "dam and fill" approach. Here, a dam is first cast from a highly thickened version of a lower-viscosity encapsulant, creating a wall around the device to be encapsulated. Alternatively, the device may be framed with a pre-moulded wall or simply contained in a cavity that has been machined or fabricated into the board. See e.g., M.M. Konarski and J. Heaton, "Electronic Packaging Design Advances Miniaturization", Circ. Assembly, 32-35 (August 1996).

The encapsulant is ordinarily designed to have high flow characteristics, and high through filler loadings, to match to a large degree the coefficients of thermal expansion ("CTE") of the carrier substrate and the semiconductor device to which it is attached, by electrically-connecting wire bonds. The high flow characteristics -- low viscosity -- allows for easy penetration in and around ultrafine-pitch wire bond connection.

Early smart card encapsulants had been rendered curable through heat cure mechanisms. That is, after application of the encapsulant composition, cure would occur through exposure to elevated temperature conditions, such as about 100°C, for periods of time, such as about 16 hours. This would be ordinarily achieved through passage on line into a heating chamber. Products of this kind have been available commercially from Dexter Electronic Materials, City of Industry, California.

Drawbacks exist to such heat-cure encapsulants, though. For instance, the heat cure step may compromise the integrity of the overall electronic device and/or substrate by virtue of the thermal exposure. In addition, the heat cure step presents a discontinuity and drag in the manufacturing throughput, particularly in view of the heating and cooling required, as well as the time required to cure the encapsulant under such heated conditions. Moreover, energy and labour requirements involved in the heat cure step add cost to the assembly of the electronic device, such as the smart card.

As a result, there has been an on-going desire to find photocurable encapsulants, because photocure mechanisms are ordinarily more rapid than heat cure mechanisms, and occur without exposure to the heat applied during heat cure. Thus, use of such photocurable encapsulants minimizes the tendency to compromise the integrity of the overall electronic device and/or substrate.

Photocurable encapsulants, even for smart card applications, are not themselves new. In the electronics industry there have been used many types of encapsulants for electronic components. Many of these encapsulants have been transparent or at least translucent.

There were two main reasons why this has been the case. Firstly when colourants such as dyes/pigments are employed to reduce transmission of light through the cured composition the cured composition with greatest thickness typically has a thickness of less than a maximum of about 700µm (the average thickness that is achievable under standard conditions is about 200µm) so that the physical limitation of the amount of material which is present makes the material relatively transparent/translucent even if coloured, as a thinner amount of any material tends to be more transparent/translucent than a thicker amount of that same material. Furthermore thinner material does not provide the desired protection for the part to which it is employed.

Secondly it is difficult to provide a composition which is opaque by including an opacifier. This latter reason is due to the fact that many of the known encapsulants compositions are uv curable for reasons of ease of processing such as those discussed above. The provision of a pigment or a dye which is sufficiently opaque in the cured material can itself deleteriously affect the cure properties of the material by interfering with the irradiation cure of the composition. The dye or pigment tends to absorb/extinguish relatively large amounts of uv radiation so that the cure of the curable component is disrupted particularly where the dye/pigment is present in relatively large amounts. Of course the more pigment/dye added to a curable composition the more opaque it becomes and the greater the extent to which it interferes with the uv curing process. The greater the absorption/extinction by the pigment/dye becomes the more acute the problem and the thinner the amount of material cured.

In particular it appears that the provision of at least certain dyes or pigments in a formulation suitable for use as encapsulant substantially affects cure through volume (CTV) of the composition. When low CTV is achieved the cured material may not be sufficiently cured to be of use, or, if cure only takes place to a relatively low degree, it may remain substantially transparent due to its relatively low thickness. In short there is a trade off between the extent to which the composition may be coloured and the extent to which it can be cured.

For example if carbon black is used as a pigment in a uv curable epoxy composition the CTV is a maximum of about 700 µm (again it is to be noted that the average is only 200µm) when a sufficient amount of carbon black is used to impart opacity and industry standard cure conditions are employed. This thickness is at its maximum value suitable for encapsulation as typically for encapsulation a CTV of at least 600-800 µm is desired on the part being encapsulated to ensure sufficient protection of the part. Accordingly even using a pigment which allows substantially above average CTV such as carbon black, means that the encapsulation process is too likely to fail to provide the minimum amount of encapsulation to be of general application as the maximum achievable thickness under standard processing conditions is close to the lower limit of what is acceptable in encapsulation processes.

For instance it is usual to seek an encapsulant composition with a CTV of about 1500 µm or greater so as to ensure CTV of at least 600-800 µm on part when the encapsulant is applied using industry standard processing techniques. This allows a wide margin of tolerance in the processing steps used to apply the encapsulant without compromising the usefulness of the end product.

Another drawback to known photocurable smart card encapsulants is the wavelength at which cure is designed to occur. That is, the memory device (or, EPROM) often used in smart card construction is particularly sensitive to wavelengths at 254 nm. At this wavelength, the EPROM may become erased. Therefore, current photocurable compositions that have been offered for sale as smart card encapsulants, but which cure at such wavelengths, are of limited utility.

### Summary of the Invention

The present invention provides a composition comprising:
(i) a uv curable component;
(ii) a component for initiating cure of the uv curable component;
(iii) an opacifying component which has a first colour which is sufficiently transparent to uv light so as to substantially unaffect cure of the uv curable component and which is activatable to change colour to a second colour which is sufficiently opaque to render the cured product of the composition substantially opaque to visible light; and
(iv) an adhesion-promoting component.

The compositions of the invention are particularly well-suited for use as an encapsulant for electronic components, as well as a potting composition and a die attachment adhesive.

The compositions of the invention have been found to be very useful as encapsulants. In particular encapsulant compositions formulated according to the present invention demonstrate a CTV of about 1500 µm or greater so as to ensure (allowing for wide manufacturing tolerances) CTV of at least 600-800 µm on part. On the other hand because of the change in colour from the opacifying component the cured material has an opaque colour imparted thereto. As above this allows a wide margin of tolerance in the processing steps used to apply the encapsulant without compromising the usefulness of the end product.

Furthermore the part/component that is encapsulated with compositions of the present invention will no longer be visible to the naked eye. For example those parts of a die/chip that could previously be seen with the naked eye are no longer visible. This is advantageous as it no longer allows information about the encapsulated part to be derived easily. Accordingly commercially sensitive information can be protected.

In short the first colour allows sufficient uv to penetrate the composition so that good CTV is achieved. When the opacifying component is activated the cured composition has sufficient opacity imparted thereto (by the change in colour) to render the material substantially opaque to uv light.

The first colour will usually represent a colourless state or a substantially transparent colour. The colour of the composition will depend on its components but for example the composition may be a straw yellow colour. On the other hand the second colour will be a dark relatively opaque colour such as dark blue or black.

In general the colour system will be a colour fast one so that the opacity conferred by the change in colour is permanent and does not reverse, in particular when the activation source for the opacifying component is removed/becomes inactive.

In particular it is desirable that the opacifying component is activatable either directly by uv irradiation and/or is activatable by an activator component which is in turn activatable by uv irradiation.

In one very useful embodiment the curable component (and/or a photoinitiator therefore) and the opacifying component (and/or an activator therefore) are selected to each be activatable by exposure to uv radiation. Desirably the components selected and the intensity/frequency of the uv radiation selected is sufficient to cause both cure of the curable component and also to activate the colour change.

In use as encapsulant there is no necessity for selectivity in the change of colour of the opacifying agent. In general the entire composition will be non-selectively exposed to the uv source so that cure of the entire composition and colour change throughout the entire composition will both take place. It is believed that the colour change happens substantially while cure is taking place.

A colour-imparting and/or fluorescent component could be optionally used as an additional component in a composition of the invention. For example pigments or dyes can be used as secondary colour-imparting agents as required. For example carbon black can be used to impart additional opacity to the composition. Such components would be employed in amounts insufficient to interfere to any substantial extent with the cure processes of the invention.

Examples of such pigments include, but are not limited to, Stellar Green T-8 available commercially from Swada (UK) Ltd., Swada Laser Red T3, Fluorescent Yellow LX 9740 commercially available from Pylam Products Inc. (USA), and Sudan Yellow 146 and Sudan Orange 220 commercially available from BASF.

Other dyes classified as xanthenes and anthraquinones may be used, particularly those which can be readily solubilised in the epoxy component in the chosen amount and do not adversely affect curing thereof. Xanthenes are characterized by the following structure:

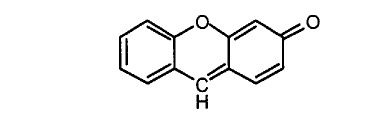

Fluorans are a class of xanthene dyes that may be used in the present invention. Particularly preferred fluorans comprise fluorescein (D&C Yellow #7), dibromofluorescein (D&C Orange #5), diiodofluorescein (D&C Orange #10), tetrabromofluorescein (D&C Red #21), and
tetrabromotetrachlorofluorescein (D&C Red #27, also known as Pylam Red #27). Anthraquinone dyes are characterized by the following structure:

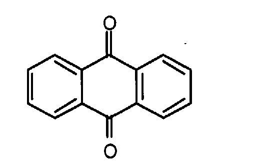

Examples of anthraquinone dyes are 7,16-dichloro-6,15-dihydro-5,9,14,18-anthrazine-tetrone (D&C Blue #9), the disodium salt of 2,2'-[(9,10-dihydro-9,10-dioxo-1,4-anthracenediyl)diimino]bis-[5-methylbenzenesulfonic acid (D&C Green #5), 1,4-bis(4'-methylanilino)anthraquinone (D&C Green #6), and 1-hydroxy-4-(4-methylanilino)anthraquinone (D&C Violet #2). D&C is the category of dyes and pigments considered safe for drugs and cosmetics by the U.S. Food and Drug Administration when in contact with mucous membranes or when ingested.

The dyes or pigments may be used in an amount of about 0.01 to about 0.1 weight percent based on the total weight of the composition. At amounts below about 0.01 % sufficient opacity may not be achieved while amounts greater than about 0.1 % may compromise the cure of the composition.
It is desirable that the encapsulant compositions of the invention comprise a uv curable epoxy component.

Suitable epoxy components for use in the present invention include: many common epoxy resins, such as those having monofunctionality and multifunctionality (for example those having two or more epoxy groups per molecule). Examples of such epoxy resins with monofunctionality include C₄-C₂₈ alkyl glycidyl ethers; C₂-C₂₈ alkyl- and alkenyl-glycidyl esters; C₁-C₂₈ alkyl- and, mono-phenol glycidyl ethers. Examples of such epoxy resins with multifunctionality include poly-phenol glycidyl ethers; cycloaliphatic epoxy resins; polyglycidyl ethers of pyrocatechol, resorcinol, hydroquinone, 4,4'-dihydroxydiphenyl methane (or bisphenol F), 4,4'-dihydroxy-3,3'-dimethyldiphenyl methane, 4,4'-dihydroxydiphenyl dimethyl methane (or bisphenol A), 4,4'-dihydroxydiphenyl methyl methane, 4,4'-dihydroxydiphenyl cyclohexane, 4,4'-dihydroxy-3,3'-dimethyldiphenyl propane, 4,4'-dihydroxydiphenyl sulfone, and tris(4-hydroxyphyenyl)methane; polyglycidyl ethers of the chlorination and bromination products of the above-mentioned diphenols; polyglycidyl ethers of novolacs; polyglycidyl ethers of diphenols obtained by esterifying ethers of diphenols obtained by esterifying salts of an aromatic hydrocarboxylic acid with a dihaloalkane or dihalogen dialkyl ether; polyglycidyl ethers of polyphenols obtained by condensing phenols and long-chain halogen paraffins containing at least two halogen atoms; phenol novolac epoxy resins; cresol novolac epoxy resins; and combinations thereof.

Among the commercially available epoxy resins suitable for use herein are polyglycidyl derivatives of phenolic compounds, such as those available under the trade names EPON 828, EPON 1001, EPON 1009, and EPON 1031, from Shell Chemical Co.; DER 331, DER 332, DER 334, and DER 542 from Dow Chemical Co.; GY285 from Ciba Specialty Chemicals; and BREN-S from Nippon Kayaku, Japan. Other suitable epoxy resins include polyepoxides prepared from polyols and the like and polyglycidyl derivatives of phenolformaldehyde novolacs, the latter of which are available commercially under the trade names DEN 431, DEN 438, and DEN 439 from Dow Chemical Company. Cresol analogs are also available commercially under the trade names ECN 1235, ECN 1273, and ECN 1299 from Ciba Specialty Chemicals. The cycloaliphatic epoxy resin, UCB CAT-002, available commercially from UCB, is desirable as well. SU-8 is a bisphenol A-type epoxy novolac available from Shell Chemicals (formerly, Interez, Inc.). In addition, UVR-6105 and 6110 (each 3,4-epoxycyclohexylmethyl-3,4-epoxycyclohexane carboxylate) and UVR-6128 [(bis-(3,4-epoxycyclohexyl) adipate], each available commercially from UCB Chemicals, are desirable for use herein, with the latter being particularly desirable. And of course combinations of the different epoxy resins are also desirable for use herein.

Of the epoxy resins set forth above only those which are not basic in nature so as to quench cations are desirable for use herein.

It is desirable in compositions of the invention that the main curable component is a cycloaliphatic epoxy component. For systems including other resins suitable opacifying components are also available. For example "Blue 55" available from Spectra Group Limited in Maumee, Ohio, US may be used with Bisphenol A or Bisphenol F epoxy resins.

Useful components for initiating cure of the uv curable component are photoinitiators such as iodonium salts. Useful iodonium salts such as those sold under the trade names UVAcure 1600 (UCB Europe, Belgium), Rhodorsile 2074 (Rhone Poulenc) and IRGACURE 250 (Ciba Speciality Chemicals).

Useful opacifying components include those colour change components/compositions disclosed in U.S. Patent Nos. 5,942,370, 5,942,554, 6,309,797 and 6,433,035, the contents of each of which being hereby incorporated in its entirety by way of reference.

The opacifying component may itself be formulated (for admixing with the other components) as a polymerisable composition for example containing a polymerisable compound, a colour precursor and an activator for the colour precursor such as an onium salt.

As described in the '554 patent, preferably, the colour precursor may be a lactone in which an aromatic ring is fused to the lactone ring, e.g.,6-(dimethylamino)-3,3-bis[4-(dimethylamino)phenyl]-1 (3H)-isobenzofuranone (crystal violet lactone (CAS No.1552-42-7)), 3,3-bis[4-(dimethylamino)phenyl]-1 (3H)-isobenzofuranone (malachite green lactone (MGL)), 2'-[bis(phenylmethyl)amino]-6'-diethylaminospirobenzofuran-1 (3H),9'-[9H]xanthen]-3-one (green dye precursor (CAS No. 34372-72-0)), 6'-(diethylamino)-3'-methyl-2'-phenylaminospiro[isobenzofuran-1 (3H),9'-[9H]xanthen]-3-one (black dye precursor (CAS No. 29512-49-0)), 3-[Bis(4-octylphenyl)amino]-3-[4-dimethylamino)phenyl]-3(3H)-isobenzofuran one (orange dye precursor (CAS No. 67697-75-0)), 3,3-Bis(1-butyl-2-methyl-1 H-indol-3-yl)-1 (3H)-isobenzofuranone (magenta dye precursor (CAS No. 50292-91-6)), 3,3-bis(1-octyl-2-methyl-1H-indol-3-yl)-1(3H)-isobenzofuranone (red dye precursor (CAS No. 50292-95-0)).

Other lactone colour precursors are represented by the formula (I), (II), (III) or (IV): 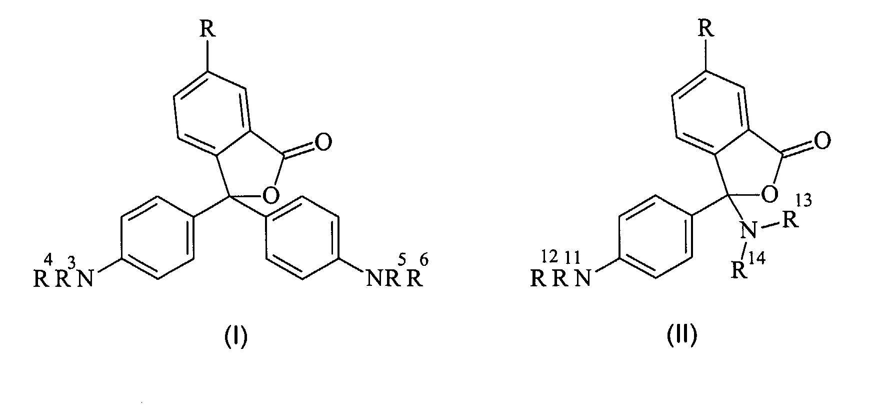 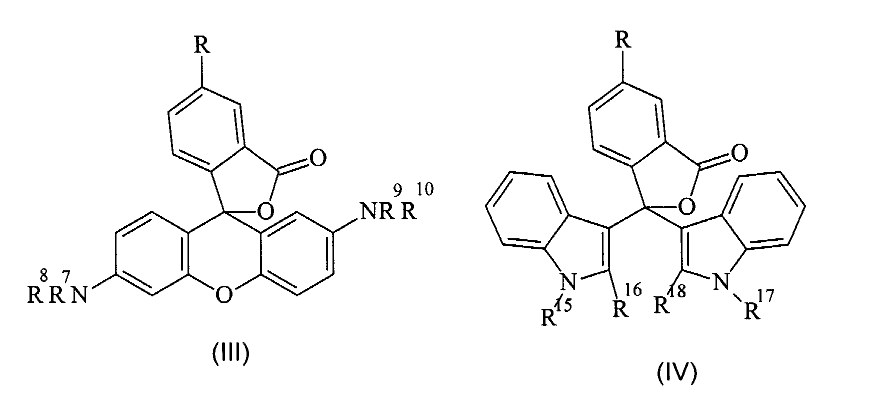 where:
R is hydrogen or an amino group having the formula --NR¹ R² wherein R¹ and R² are the same or different and represent hydrogen, aryl, or a C₁ -C₈ alkyl group with the proviso that only one of R¹ and R² may be hydrogen; and each of R³ to R¹⁸, are the same or different and represent substituents selected from hydrogen, aryl, and C₁ to C₈ alkyl group and R⁹ and R¹⁰ are a substituent selected from hydrogen, aryl, phenylmethyl, and C₁ and C₈ alkyl group with the proviso that only one of said substituents attached to each nitrogen atom may be hydrogen.

In general the colour precursor will change to its coloured state on exposure to uv radiation or an acceptor or donor species may be required to convert the colour precursor to a coloured state. An onium salt is useful as such a species. Suitable onium salts include those described above. Indeed it is desirable that the acceptor or donor species can also act as a photoinitiator for the curable component. In the case of epoxy curable materials and colour precursors such as those disclosed above onium salts have such desired bifunctionality.

Such compositions are thus curable and colourable on exposure to actinic radiation. The compositions of the invention will be formulated to be sufficiently transparent to allow CTV of at least 1500 µm on exposure to uv radiation having broad range of wavelengths in the range 290 to 540 nm for a period of between 20 seconds and 60 seconds. The compositions are initially substantially a first colour (a light colour) and the colour changes to a dark colour on exposure to UV radiation.

The opacifying components of the present invention are available from Spectra Group Limited in Maumee, Ohio, U.S. an example of which is "Blue 50", a cycloaliphatic epoxy together with a proprietary "colour package".

The memory device (or, EPROM) often used in smart card construction is particularly sensitive to wavelengths at 254 nm. At this wavelength, the EPROM may become erased. Accordingly, the photocurable compositions of the present invention can be selected so that both the cure of the composition and the colour change occur when exposure to uv radiation of sufficient intensity and which may be designed to be curable at wavelengths greater than about 290 nm are particularly suitable for smart card applications.

As the adhesion promoter component, silanes, such as cycloaliphatic silanes [e.g., beta-3,4-epoxycyclohexyl ethyl trimethoxy silane] is commercially available from OSI under the trade designation A-186, epoxy silanes [e.g., glycidyl triethoxysilane (commercially available from OSI under the trade designation A-187)]. In addition, trialkoxysilyl isocyanurate derivatives (e.g., Y-11597 from OSI) may also be used.

Optionally the compositions of the invention include a photosensitiser component. As a photosensitiser, many suitable materials are available, though thioxanthones, like isopropyl thioxanthones are desirable. For instance, isopropyl thioxanthone is a suitable choice, as is diethyl-thioxanthone ("DETX"). In addition, other thioxanthones, such as 2-methyl-thioxanthone, 2,4-dichloro-thioxanthone, 2-chloro-thioxanthone, 2,4-dimethyl-thioxanthone, 2,4-diethyl-thioxanthone and 2,4-diisopropyl-thioxanthone may be used as well. Other photosensitizers particularly well suited for use with catonic photoinitiators include anthracene, perylene, phenothazine, 1,2 benzathracene, coronene, pyrene, and tetracene. Of course combinations of these photosensitizers may be used as well. Spectra Group Limited's sensitiser sold under product code Hu470 works well with the product sold under the product name "Blue 50".

Typically, the composition includes up to about 98 weight percent, such as an amount within the range of about 45 weight percent to about 90 weight percent, for instance from about 35 to about 80 weight percent, desirably about 60 to about 75 weight percent, of the epoxy resin component by weight of the total composition, up to about 5 weight percent of the adhesion promoter component by weight of the total composition, up to about 5 weight percent, such as about 0.01 to about 2.5 weight percent of the cationic photoinitiator, by weight of the total composition and optionally up to about 1 weight percent, such as about 0.01 to about 1 weight percent, of a photosensitizer by weight of the total composition. Of course, depending on the particular set of properties desirable for a composition destined for a specific purpose these values may vary somewhat. Such variation may be achieved without undue experimentation by those persons of skill in the art.

An inorganic filler component may be useful in the inventive composition. The inclusion of an inorganic filler component allows for adjustments to the CTE of the encapsulant, so that it may be more closely matched to the substrate and microelectronic device with which it is to be used.

For instance, the inorganic filler component may often include reinforcing silicas, such as fused silicas, and may be untreated or treated so as to alter the chemical nature of their surface. Virtually any reinforcing fused silica may be used.

Particularly desirable ones have a low ion concentration and are relatively small in particle size (e.g., on the order of about 12 µm, with a median of up to about 30 µm and as low as less than about 2 µm), such as the Silbond materials, commercially available under the tradename SILBOND FW300EST from Quartzwerke, supplied by Sibelco, Belgium.

Other desirable materials for use as the inorganic filler component include those constructed of or containing aluminum oxide, silicon nitride, aluminum nitride, silica-coated aluminum nitride and micronized quartz, provided they are not basic in nature.

Conductive - thermally and/or electrically ― fillers may also be included in the inventive compositions. Examples of such fillers include silver, gold, nickel. A particularly desirable electrically conductive filler is gold, such as in the form of gold coated polymer spheres, particularly those having monodispersed diameters from 3µm to 50 µm supplied commercially by Sekisui Chemicals Co. Ltd., Japan.

A plasticiser may also be included in the inventive composition to modify the glass transition temperature ("Tg") and modulus, examples of which include those available commercially from Union Carbide, such as under the trade designations TONE Polyol 301 and 310.

In addition, rheology modifiers, such as thickeners and thixotropes, like fumed silica, may be included in the inventive compositions.

The invention also relates to use of a composition comprising:
(i) a uv curable component;
(ii) a component for initiating cure of the uv curable component;
(iii) an opacifying component which has a first colour which is sufficiently transparent to uv light so as to substantially unaffect cure of the uv curable component and which is activatable to change colour to a second colour which is sufficiently opaque to render the cured product of the composition substantially opaque to visible light,
as an encapsulant for encapsulating electronic components.

The invention also extends to use of a composition of the invention as described above as an encapsulant for encapsulating electronic components.

The present invention further relates to an assembly comprising an electronic component attached to a substrate the electronic component being encapsulated by a composition according to the present invention.

The present invention also provides a method for the attachment of integrated circuits, such as smart card modules, to a carrier substrate, such as flex or smartcard tape, using the compositions so described. More specifically, the method includes the steps of applying such a composition to the carrier flex or smartcard tape, activating the composition prior to or after application thereof through exposure to radiation in the electromagnetic spectrum, such as a wavelength in a range of 200 to 600 nm, to such an extent that a desired initial tackiness is maintained and no skin formation on the surface of the composition occurs, positioning the integrated circuit onto the circuit board, and establishing electrical interconnections through wire bonds.

### Brief Description Of The Drawings

FIG. 1 is a cross-section view of a smart card with a wire bonded integrated circuit disposed therein; and
FIG. 2 is a photographic image of the precure and 10 and 30 second cure product of a composition of the Examples which has been dispensed for use as an encapsulant on an electronic circuit.

### Detailed Description Of The Invention

As noted above, the inventive photocurable compositions are particularly useful as encapsulants for wire bonds, which electrically connect a semiconductor device to a carrier substrate.

The photocurable composition of the present invention is capable of curing upon exposure to radiation in the electromagnetic spectrum having a wavelength greater than about 290 nm and reaction products of the composition are substantially opaque to visible light.

It is significant to note that the compositions of the present invention may be designed to cure at a wavelength greater than about 290 nm. That is, in the context of encapsulating electronic components destined for use in connection with smart card assembly, the integrity of the EPROM could be compromised in the event that a wavelength of 254 nm (or in the near regions of 254 nm) is used to photocure the composition.

Referring to FIG. 1, a cross-section view of a smart card module assembly 1 is shown, in which, a carrier substrate, such as a module carrier tape 2 (such as glass-reinforced epoxy), is contacted with bond pads 3A, 3B and 3C. Die 4 is positioned over bond pad 3C and wire connection 5 are established between die 4 and bond pads 3A and 3B. The inventive photocurable encapsulant composition 6 is dispensed as an encapsulant glob over smart card module assembly 1.

More specifically, the wire bonded semiconductor chip assembly is bonded face up onto the smart card tape with five wires attached from the bond point(s) on the semiconductor chip to the bond pad(s) on the smart card tape connections. These bonds and the faced up wire-bonded semiconductor chip assembly are protected from environmental and other contaminates, and mechanical stresses, by the inventive encapsulant composition. As noted, encapsulation may be achieved by glob, or by dam and fill for larger devices whose wires loop higher than those of smaller devices.

The inventive compositions are applicable to other integrated circuit assemblies where it is desirable to maintain a fixed positional relationship between a die and a substrate during processing through a photocure process, particularly where a memory device such as an EPROM is involved in the assembly, such as photocurable anisotropically conductive pastes and photocurable die attach materials.

The following examples are presented to further illustrate the invention, without intending to narrow or depart from its scope.

### EXAMPLES

### Example 1

Cycloaliphatic resin (Union Carbide, UVR 6128), 55.2%, pre-oligomerised CER (CAT002, UCB), 33.68%, organosilane (Silquest 187, OSI) 2.0%, fumed silica, 2.5%, iodonium salt photo-initiator, 2.5%, isopropyl thiaxanthone, 0.02%, "Blue 50" (Spectra Group Limited) 2.0%, were blended together and deaerated in the absence of light.

The resulting mixture was a straw yellow transparent liquid.

Approximately 200mg of this mixture was dispensed onto a glass slide so as to encapsulate a chip/die on the slide. The composition was cured with uv light with an intensity of 100mW/cm² for 30 seconds.

The resulting cured material was solid and opaque and dark blue/black in colour. A CTV measurement of this formulation cured with uv light with an intensity of 100mW/cm² for 30 seconds showed an average cure depth of 1600 microns. **FIG. 2** shows the precure and 10 and 30 second cure product of the composition which has been dispensed for use as an encapsulant on the chip/die.

### Example 2

Another formulation was prepared which incorporated a further opacifying component.
Cycloaliphatic resin (Union Carbide, UVR 6128), 55.1%, pre-oligomerised CER (CAT002, UCB), 33.68%, organosilane (Silquest 187, OSI) 2.0%, fumed silica, 2.5%, iodonium salt photo-initiator, 2.5%, isopropyl thiaxanthone, 0.02%, micronised carbon black, 0.1 %, "Blue 50" (Spectra Group Limited) 2.0%, were blended together and deaerated in the absence of light.

The resulting mixture was a straw yellow transparent liquid with black particulate suspension.

Approximately 200mg of the mixture was dispensed onto a glass slide so as to encapsulate a chip/die on the slide. The composition was cured with uv light with an intensity of 100mW/cm² for 30 seconds.
The resulting cured material was solid and opaque and is black in colour.
A cure through volume measurement of this formulation cured with uv light with an intensity of 100mW/cm² for 30 seconds showed an average cure depth of 1000 microns.

### Example 3

Another formulation of the present invention was prepared in which isopropyl thiaxanthone was replaced by Hu470.

Cycloaliphatic resin (Union Carbide, UVR 6128), 55.1 %, pre-oligomerised CER (CAT002, UCB), 33.68%, organosilane (Silquest 187, OSI) 2.0%, fumed silica, 2.5%, iodonium salt photoinitiator, 2.5%, photosensitizer (Spectra Group Limited Hu470) 0.25%, "Blue 50" (Spectra Group Limited) 2.0%, were blended together and deaerated in the absence of light.

The resulting mixture was a straw yellow transparent liquid.

Approximately 200mg of this mixture was dispensed onto a glass slide so as to encapsulate a chip/die on the glass slide. The composition was then cured with uv light with an intensity of 100mW/cm² for 30 seconds.
The resulting cured material was solid and opaque and black in colour.
A cure through volume measurement of this formulation cured with uv light with an intensity of 100mW/cm² for 30 seconds showed an average cure depth of 1800 microns.

### Example 4

Another formulation of the present invention was prepared using Bis phenol A epoxy resin with "Blue 55".

Bisphenol A epoxy resin (Nippon Kayaku Re310S), 90.98%, Organosilane (Silquest 187, OSI) 2.0%, Fumed Silica, 2.5%, lodonium salt photo-initiator, 2.5%, Isopropyl thiaxanthone, 0.02%, "Blue 50" (Spectra Group Limited) 2.0%, were blended together and deaerated in the absence of light.

The resulting mixture was a straw yellow transparent liquid.

Approximately 200mg of the mixture was dispensed onto a glass slide so as to encapsulate a chip/die on the glass slide. The composition was cured with uv light with an intensity of 100mW/cm² for 30 seconds.

The resulting cured material was solid and opaque and black in colour.
A cure through volume measurement of this formulation cured with uv light with an intensity of 100mW/cm² for 30 seconds showed an average cure depth of 1600 microns.

In all of the above examples there was experienced, and with compositions of the invention there in general exists, a delay cure which will further improve the depth of cure. The extent of this depends on the duration of exposure to uv and the temperature at which cure is initiated and at which the cured composition is held. Generally over a period improvement in cure through volume due to this delayed cure amounts to about 200-300microns in the depth of cure.

It is appreciated that certain features of the invention, which are, for clarity, described in the context of separate embodiments, may also be provided in combination in a single embodiment. Conversely, various features of the invention which are, for brevity, described in the context of a single embodiment, may also be provided separately or in any suitable subcombination.

The words "comprises/comprising" and the words "having/including" when used herein with reference to the present invention are used to specify the presence of stated features, integers, steps or components but does not preclude the presence or addition of one or more other features, integers, steps, components or groups thereof.

## Claims

1. A curable composition comprising:
(i) a uv curable component;
(ii) a component for initiating cure of the uv curable component;
(iii) an opacifying component which has a first colour which is sufficiently transparent to uv light so as to substantially unaffect cure of the uv curable component and which is activatable to change colour to a second colour which is sufficiently opaque to render the cured product of the composition substantially opaque to visible light; and
(iv) an adhesion-promoting component.

2. A composition according to Claim 1, wherein the composition is capable of curing through a volume of at least about 1 mm.

3. A composition according to Claim 1 or Claim 2, wherein the composition is capable of curing radiation at a wavelength of at least 290 nm.

4. A composition according to any preceding claim further comprising an inorganic filler component.

5. A composition according to any preceding claim, wherein the composition is capable of curing in a time of less than about 15 seconds.

6. A composition according to any preceding claim wherein the uv curable component comprises an epoxy resin material.

7. A composition according to Claim 6, wherein the epoxy resin component is a member selected from the group consisting of cycloalphatic epoxy resins; C₄-C₂₈ alkyl glycidyl ethers; C₂-C₂₈ alkyl- and alkenyl-glycidyl esters; C₁-C₂₈ alkyl-, mono- and poly-phenol glycidyl ethers; polyglycidyl ethers of pyrocatechol, resorcinol, hydroquinone, 4,4'-dihydroxydiphenyl methane, 4,4'-dihydroxy-3,3'-dimethyldiphenyl methane, 4,4'-dihydroxydiphenyl dimethyl methane, 4,4'-dihydroxydiphenyl methyl methane, 4,4'-dihydroxydiphenyl cyclohexane, 4,4'-dihydroxy-3,3'-dimethyldiphenyl propane, 4,4'-dihydroxydiphenyl sulfone, and tris(4-hydroxyphyenyl)methane; polyglycidyl ethers of the chlorination and bromination products of the above-mentioned diphenols; polyglycidyl ethers of novolacs; polyglycidyl ethers of diphenols obtained by esterifying ethers of diphenols obtained by esterifying salts of an aromatic hydrocarboxylic acid with a dihaloalkane or dihalogen dialkyl ether; polyglycidyl ethers of polyphenols obtained by condensing phenols and long-chain halogen paraffins containing at least two halogen atoms; phenol novolac epoxy resins; cresol novolac epoxy resins; and combinations thereof.

8. A composition according to Claim 6 or Claim 7 wherein the epoxy resin component is a cycloaliphatic epoxy resin, Bisphenol A epoxy resin, Bisphenol F epoxy resin and combinations thereof.

9. A composition according to any one of claims 6 to 8, wherein the epoxy resin component is used in an amount of up to about 98 percent by weight of the total composition.

10. A composition according to any preceding claim wherein the opacifying component comprises a lactone in which an aromatic ring is fused to the lactone ring.

11. A composition according to any preceding claim wherein the component for initiating cure of the curable component also participates in the colour change of the opacifying component.

12. A composition according to any preceding claim wherein the component for initiating cure of the curable component is an onium salt.

13. A composition according to any preceding claim wherein the adhesion promoting component comprises silane.

14. A composition according to claim 13 wherein the silane is selected from the group consisting of: cycloaliphatic silanes, epoxy silanes, and amino silanes and combinations thereof.

15. A composition according to any preceding claim wherein the composition further comprises a photosensitiser component.

16. A composition according to Claim 15, wherein the photosensitiser component is selected from the group consisting of thioxanthones, anthracene, perylene, phenothazine, 1,2 benzathracene, coronene, pyrene, tetracene and combinations thereof.

17. A composition according to Claim 15 or Claim 16 wherein the photosensitiser is a thioxanthone.

18. A composition according to any one of Claims 15 to 17 wherein the photosensitiser is used in an amount within the range of about 0.01 to 1 percent by weight of the total composition.

19. A composition according to any preceding claim wherein the component for initiating cure of the uv curable component is present in an amount within the range of about 0.1 to about 2 percent by weight of the total composition.

20. A composition according to any preceding claim, further comprising a dye or pigment.

21. A smart card module assembly, comprising:
a carrier substrate dimensioned to receive a die;
a die having two surfaces, a first of which having bond pads disposed thereon and a second of which dimensioned for placement on the carrier substrate so that the bond pads on the first surface of the die are in a position relative to the bond pads on the carrier substrate to make electrical connection therewith by way of the wire connectors;
a plurality of bond pads, some of which being positioned on one surface of the die and others of which being positioned on the carrier substrate;
a plurality of wire connectors; and
a composition according to any preceding claim, wherein the second surface of the die is disposed on the carrier substrate so that the bond pads on the first surface of the die are in a position relative to the bond pads on the carrier substrate to make electrical connection therewith by way of the wire connectors, and wherein the composition is disposed over at least a portion of the smart card module assembly so as to cover the wire bond connections established.

22. A smart card comprising:
a plastic card; and
a smart card module assembly of Claim 21 having been exposed to radiation in the electromagnetic radiation at a wavelength of at least 290 nm, encased in the plastic card.

23. A method for the attachment of an integrated circuit to a carrier substrate, the steps of which include
applying a composition according to any one of Claims 1 to 20 to the carrier substrate;
activating the composition prior to or after application thereof through exposure to radiation in the electromagnetic spectrum; and
positioning the integrated circuit onto the circuit board and establishing electrical interconnection therebetween; and
optionally, curing the composition at a temperature between 60 and 140°C.

24. Use of a composition comprising:
(i) a uv curable component;
(ii) a component for initiating cure of the uv curable component;
(iii) an opacifying component which has a first colour which is sufficiently transparent to uv light so as to substantially unaffect cure of the uv curable component and which is activatable to change colour to a second colour which is sufficiently opaque to render the cured product of the composition substantially opaque to visible light,
as an encapsulant for encapsulating electronic components.

25. Use of a composition according to any one of Claims 1 to 20 as an encapsulant for encapsulating electronic components.
